Europäisches Patentamt

European Patent Office

Office européen des brevets

(19)

(11) Publication number: **0 425 677 B1**

(12) **EUROPEAN PATENT SPECIFICATION**

(45) Date of publication of patent specification: **12.07.95**  (51) Int. Cl.⁶: **C09D 5/00**

(21) Application number: **90902390.5**

(22) Date of filing: **29.01.90**

(86) International application number:
**PCT/JP90/00102**

(87) International publication number:
**WO 90/08809 (09.08.90 90/19)**

(54) **CONDUCTIVE PASTE COMPOSITION AND CURING THEREOF.**

(30) Priority: **30.01.89 JP 17765/89**
**14.03.89 JP 59568/89**

(43) Date of publication of application:
**08.05.91 Bulletin  91/19**

(45) Publication of the grant of the patent:
**12.07.95 Bulletin  95/28**

(84) Designated Contracting States:
**CH DE FR GB LI**

(56) References cited:
**FR-A- 2 441 647       JP-A- 5 578 070**
**JP-A- 5 670 065       JP-A-58 104 971**
**JP-A-60 245 601       US-A- 4 129 489**

**WPIL, FILE SUPPLIER, accession no.**
**86-024298 [04], Derwent Publications Ltd,**
**London, GB; & JP-A-60 245 601**

(73) Proprietor: **Asahi Kasei Kogyo Kabushiki**
**Kaisha**
**2-6, Dojimahama 1-chome**
**Kita-ku**
**Osaka-shi**
**Osaka 530 (JP)**

(72) Inventor: **Otsuka, Masahiko**
**Asahi Kasei Nishi Apartment 952**
**100, Kawanarijima**
**Fuji-shi**
**Shizuoka 416 (JP)**
Inventor: **Ishimura, Hidekazu**
**85-173, Hoshiyama**
**Fujinomiya-shi**
**Shizuoka 418 (JP)**
Inventor: **Masui, Yuji**
**Endo Apartment**
**68, Aoshima**
**Fuji-shi**
**Shizuoka 417 (JP)**

(74) Representative: **Schübel-Hopf, Ursula**
**Strehl Schübel-Hopf Groening & Partner**
**Patentanwälte**
**Postfach 22 14 55**
**D-80504 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

FIELD OF THE INVENTION

This invention relates to a method of curing an electrically conductive paste composition for use in electric and electronic fields and to an electrically conductive paste composition. More specifically, this invention relates to a method of curing a paste composition having a function of electrically conductive connection and adhesion such as connection of electrically conductive circuits and terminals, applicable to electronic appliance parts and printed circuit boards, and a paste composition.

The paste composition of this invention is designed so as to be subjected to a curing method which comprises electron beam curing and heat curing of the paste composition in combination.

BACKGROUND OF THE INVENTION

In recent years, an electrically conductive coating composition and an electrically conductive adhesive in a so-called paste form, which are produced by incorporating a large amount or fine particle-like silver flakes, copper powders or carbon particles into an organic polymer binder or an oligomer, (both to be referred to as an electrically conductive paste hereinafter) have been put to practical use and are widely used.

These electrically conductive pastes are used to form conductor circuits in steps of manufacturing printed circuit boards or hybrid IC's. And, these electrically conductive pastes are also used as a resistor in circuit formation. Further, pastes of this type are used not only for the above circuit formation but also as an adhesive for various electronic parts such as a film switch and resistor, liquid crystal panels and LED's.

Further, as one means of preventing an electromagnetic inference which is a hot social problem at present, an electrically conductive paste is applied onto printed wiring circuits. That is because the applied electrically conductive paste works as a shield against electromagnetic waves generated within circuits and prevents cross talk between printed wirings. Thus, this application of a paste is a general practice which an increasing number of manufacturers are employing.

The requirements for reliability of these electrically conductive pastes are severe, and these pastes are required to have high heat resistance, adhesion and humidity resistance. Conventionally developed, electrically conductive pastes contain a thermosetting resin as a binder and are expected to have improved properties for heat resistance, adhesion, etc. However, these pastes are uneconomical, since the curing thereof requires (1) a large amount of energy, (2) heating time and (3) a large floor space for placing a heating apparatus. Moreover, since many substrates to which an electrically conductive paste is applied are formed of synthetic resins, heating of such substrates for a long period of time causes deterioration and deformation of the substrates, and long-term reliability is sometimes impaired. Thus, materials which are heat-curable for a short period of time are strongly desired. However, no material has been found which is on a satisfactory level.

It is therefore expected to develop a method which makes it possible to cure an electrically conductive paste by irradiation with active energy beams such as UV radiation, electron beam, at room temperature or close to room temperature or for such a short period of time that causes no deterioration of a substrate.

Since, however, UV radiation has no capability of penetrating through a filler, it is difficult to apply UV radiation curing to films which contain a high concentration of electrically conductive powders for electrical conductivity. And, since a photoinitiator and a sensitizer are used in large amounts, deterioration of films sometimes occurs. On the other hand, electron beam curing is free from a limitation in which a filler imposes on the UV radiation curing and the problem of film deterioration which an initiator causes. However, the electron beam curing involves a drawback in that a film formed by electron beam curing has a very poor initial electrical conductivity or a very poor electrical conductivity in a high-temperature or high-humidity environment as compared with a film formed by heat curing. Further, the penetration ability of electron beam imposes a limitation not only on a film thickness but also on a film form.

In order to overcome these drawbacks, e.g., JP-A-56-90590 discloses a method in which a film formed by applying a silver filler-containing electron beam-curable coating composition is irradiated with an electron beam and then heated. This method remarkably improves the initial electrical conductivity.

JP-A-62-200703 discloses a method of forming a resistance circuit having various resistance values by heating an electron beam-curable resistance paste containing a carbon-based filler before, during or after electron beam irradiation. This method attempts to improve properties of electron beam-cured products by introducing a heating step as an auxiliary step.

However, the properties of films obtained by the above curing methods are still not satisfactory in view of long-term reliability which is now required. In particular, when air-oxidizable copper, nickel, are used as electrically conductive powders, the curing methods disclosed by the above two publications cannot give sufficient performance.

SUMMARY OF THE INVENTION

It is an object of this invention to provide a curing method using an electron beam and heat in combination, which gives a cured product having excellent initial electrical conductivity, while maintaining a long-term reliability under a high-temperature and high-humidity environment, and being free from a migration problem, and which makes it possible to remarkably improve curing conditions for curing an electrically conductive paste composition, and a composition which is applicable to the method.

PREFERRED EMBODIMENTS OF THE INVENTION

This invention relates to a method of curing an electrically conductive paste composition which comprises irradiating with an electron beam and heating in combination an electrically conductive paste composition comprising

(A) 5 to 85 parts by weight of a resin paste comprising 10 to 90% by weight of an electron beam-curable resin (a) selected from resins having unsaturated group(s) in the molecule or in the side chain thereof, and 90 to 10% by weight of at least one heat-curable resin (b) selected from an amino resin, a phenolic resin, an epoxy resin or a polyisocyanate resin, and

(B) 95 to 15 parts by weight of an electrically conductive fine powder, having an average particle diameter of 1 to 50$\mu$m, wherein the heating is carried out at 100 to 250°C for 30 minutes to 15 seconds.

Furthermore, this invention relates to an electrically conductive paste composition consisting essentially of:

(A) 5 to 85 parts per weight of a resin paste comprising 10 to 90% by weight of an electron beam-curable resin (a) selected from resins having unsaturated group(s) in the molecule or in the side chain thereof, and 90 to 10% by weight of at least one resin (b) selected from an amino resin, a phenolic resin, an epoxy resin or a polyisocyanate resin, and

(B) 95 to 15 parts by weight of an electrically conductive fine powder having an average particle diameter of 1 to 50$\mu$m.

In a film obtained by the curing method of this invention, the electron beam-curable resin and the heat-curable resin contribute to the curing individually or in combination. Therefore, the film strength is improved to a great extent and the film performances such as heat resistance and humidity resistance are greatly improved as compared with films formed of an electron beam-curable resin alone. Further, in a film produced of the paste composition of this invention, the electron beam-curable resin and the heat-curable resin, the latter being selected from an amino resin, a phenolic resin, an epoxy resin or a polyisocyanate resin contribute to the curing individually or in combination. Therefore, the film strength is improved to a great extent and the film performances such as heat resistance and humidity resistance are greatly improved as compared with films formed of a system using a an electron beam-curable resin alone.

The electrically conductive paste composition containing an electron beam-curable resin and a heat-curable resin, provided by this invention, will be explained below. The first embodiment of such a composition is a composition containing, as essential components, a resin which undergoes a curing reaction by irradiation with an electron beam and a resin which undergoes a curing reaction by heating.

The above resin which undergoes a curing reaction by irradiation with an electron beam, i.e., an electron beam-curable resin, is a resin having unsaturated group(s) in the molecule or the side chain thereof. Specific examples of such resins include an unsaturated polyester resin, polyester (meth)acrylate resin, epoxy(meth)acrylate resin, polyurethane (meth)acrylate resin, polyether (meth)acrylate resin, polyallyl compound, polyacrylated silicon resin and polybutadiene. An epoxy (meth)acrylate resin is preferred. These resins are used alone or in combination.

Further, for viscosity decreasing, for example, the following monomers and oligomers having unsaturated group(s) may be added: methyl (meth)acrylate, ethyl (meth)acrylate, propyl (meth)acrylate, butyl (meth)acrylate, 2-ethylhexyl (meth)acrylate, (meth)acrylic acid, dimethylaminomethyl (meth)acrylate, polymethylene glycol polyacrylate, polypropylene glycol polyacrylate, trimethylolpropane triacrylate, triallyl trimellitate and triallyl isocyanurate.

The above resins which undergo a curing reaction by heating are so-called thermosetting resins, and include an amino resin, a phenolic resin, an epoxy resin and a polyisocyanate resin.

Examples of the amino resin are resins produced by the addition condensation of amino group-containing compounds such as urea, melamine, benzoguanamine, dicyandiamide, and formaldehyde; and resins produced by etherification thereof with alcohols such as methanol, ethanol, isopropyl alcohol, butanol. A conventional catalyst may be added to these amino resins as required. Examples of the catalyst include p-toluenesulfonic acid and p-toluenesulfonic acid amine salt.

Examples of the phenolic resin are resol-type resins produced by the addition condensation of phenols such as phenol, cresols, other alkyl phenols or bisphenols and aldehydes such as formaldehyde or acetaldehyde; and resins produced by the etherification thereof with alcohols such as methanol, ethanol, isopropyl alcohol, butanol. Novolak-type resins may be used in some cases.

Examples of the epoxy resin are those having at least two epoxy groups in the molecule thereof, such as glycidyl ethers, glycidyl esters, glycidyl amines, linear aliphatic epoxides and alicyclic epoxides. A curing agent or a catalyst may be incorporated with the epoxy resin.

Examples of the polyisocyanate resin are those having at least two isocyanate groups in the molecule thereof, such as an aliphatic polyisocyanate, alicyclic polyisocyanate, aromatic polyisocyanate, and adducts of these with alcohols or water. The polyisocyanate resin may contain a curing agent or a catalyst as required.

The above thermosetting resins may be used alone or in combination. The use of at least one resin selected from the above amino resins and phenolic resins is preferred. The melamine resin of the amino resins is more preferred.

In the method of curing the electrically conductive paste composition, provided by this invention, the electron beam-curable resin (a)/heat-curable resin (b) mixing ratio (a/b) is 10-90% by weight/90-10% by weight. When the amount of the electron beam-curable resin (a) is less than 10% by weight, the curing reaction takes a long period of time and a high curing temperature is required. Therefore, the coated material is unavoidably warped and distorted. When this amount is more than 90% by weight, it is impossible to produce a film having high reliability under high-temperature and high-humidity environments. The electron beam-curable resin(a)/heat-curable resin(b) mixing ratio is preferably 15 to 50% by weight/85-50% by weight.

Further, the following electron beam-curable and heat-curable composition can be also used as another embodiment of the resin composition used in the curing method of this invention. That is, examples of such a composition are resin compositions containing an epoxy resin, a cationic polymerization catalyst which imparts electron beam curability to the epoxy resin such as a sulfonium salt, diazonium salt, and a curing agent which imparts heat-curability thereto such as an amine, anhydride, Novolak-type phenolic resin. Such resin compositions can also undergo a curing reaction either by electron beam irradiation or heating.

Furthermore, as another resin composition, usable are resin compositions comprising the foregoing resins having unsaturated group(s) in the molecule or side chain thereof and a heat polymerization initiator such as a peroxide or an azo compound. These resin compositions can undergo a curing reaction either by electron beam irradiation or heating.

In the electrically conductive paste composition of this invention, the mixing ration (a/b) between the electron beam-curable resin (a) and at least one resin (b) selected from an amino resin, phenolic resin, epoxy resin or polyisocyanate resin is 10 to 90% by weight/90 to 10% by weight. When the amount of the electron beam-curable resin (a) is less than 10% by weight, the curing reaction takes a long period of time and a high curing temperature is required. Therefore, the coated material is unavoidably warped and distorted. When the amount of the electron beam-curable resin (a) is more than 90% by weight, it is impossible to produce a film having high reliability under high-temperature and high-humidity environments. The electron beam-curable resin (a)/resin(b) mixing ratio (a/b) is preferably 15 to 50% by weight/85 to 50% by weight.

In the method of curing an electrically conductive paste composition, provided by this invention, and the electrically conductive paste composition of this invention, examples of the electrically conductive powder are metallic powders such as gold, silver, copper, nickel, chromium, palladium, aluminum, tungsten, molybdenum and platinum and inorganic or organic powders coated with these metallic powders; powders of metal oxides such as silver oxide, indium oxide, tinoxide, zinc oxide and ruthenium oxide and powders coated with these oxides; carbon black and graphite. These electrically conductive fine powders are used alone or in combination. These powders have a granular, spherical, flake, scale, plate, dendritic or cubic form, and the average particle diameter thereof is 1 to 50 $\mu$m. Electrically conductive fine powders of copper or nickel are preferred, and more preferred is a copper powder selected from copper powders having a dendritic form, scale form or spherical form and an average particle diameter of 1 to 50 $\mu$m. In addition, the average particle diameter means a volume average particle diameter measured, e.g., by laser diffractometry.

4

In this invention, the mixing ratio between the resin paste (A) comprising the electron beam-curable resin (a) and the heat-curable resin(b) and the electrically conductive fine powder (B) (A/B) is 5 to 85 parts by weight/95 to 15 parts by weight. When the amount of the resin paste (A) is less than 5 parts by weight, the resultant film is brittle and its electrical conductivity is low. When this amount is more than 85 parts by weight, no sufficient electrical conductivity is obtained. The mixing ratio (A/B) is preferably 10 to 50 parts by weight/90 to 50 parts by weight.

The electrically conductive paste composition of this invention may contain an organic fatty acid in order to improve the electrical conductivity property. The organic fatty acid means an aliphatic compound having at least one carboxyl group in the molecule thereof, such as saturated carboxylic acids, unsaturated carboxylic acids and alicyclic carboxylic acids. Specific examples of the saturated carboxylic acids include acetic acid, propionic acid, butyric acid, valeric acid, lauric acid, myristic acid, palmitic acid, stearic acid, oxalic acid, malonic acid, succinic acid, glutaric acid, adipic acid, pimelic acid, suberic acid, azelaic acid and sebacic acid. Specific examples of the unsaturated carboxylic acids include acrylic acid, methacrylic acid, crotonic acid, oleic acid, linoleic acid, linolenic acid, fumaric acid and maleic acid. Specific examples of the alicyclic carboxylic acids include cyclohexane carboxylic acid, hexahydrophthalic acid and tetrahydrophthalic acid. These acids are used alone or in combination, and derivatives of these may be also used. Oleic acid, linoleic acid and linolenic acid are preferred.

The amount of the organic fatty acid per 100% by weight of the electrically conductive paste composition of this invention is 0.05 to 10% by weight, preferably 0.1 to 5% by weight.

The electrically conductive paste composition of this invention may contain a phenolic compound in order to improve the electrical conductivity property. The phenolic compound means a compound having a phenolic hydroxyl group. Specific examples thereof are phenol, catechol, pyrocatechol, hydroquinone, pyrogallol, fluoroglycine, gallic acid and urushiol. These may be used alone or in combination, and their derivatives may also be used. Pyrogallol is preferred.

The amount of the above phenolic compound per 100% by weight of the electrically conductive paste composition of this invention is 0.1 to 10% by weight, preferably 1 to 5% by weight.

The electrically conductive paste composition of this invention may contain a 1,3-dicarbonyl compound in order to improve the film performance. The 1,3-dicarbonyl compound means a compound having two carbonyl groups in the 1 and 3-positions. Specific examples of such a compound are acetylacetone, propionylacetone, butyrylacetone, valerylacetone, lauroylacetone, acryloylacetone, methacroylacetone, linolylacetone, linolenylacetone, 2,4,-hexandione, 3,5-heptandione and 3,5-octandione. These compounds may be used alone or in combination, and derivatives of these may also be used. Acetylacetone is preferred.

The amount of the 1,3-dicarbonyl compound per 100% by weight of the electrically conductive paste composition of this invention is 0.05 to 10% by weight, preferably 0.1 to 5% by weight.

The organic fatty acid, phenolic compound and 1,3-dicarbonyl compound may be used alone or in combination. Further, not only may these be incorporated into the electrically conductive paste composition of this invention, but they may also be incorporated into the electrically conductive fine powder before production of the electrically conductive paste composition.

If necessary, the electrically conductive paste composition may be prepared as follows. Each or a mixture of the above three compounds is dissolved in a solvent, an electrically conductive fine powder is incorporated thereto to carry out surface treatment, the solvent is filtered off or directly removed, and then the electrically conductive fine powder was recovered and mixed with other components.

The electrically conductive paste composition of this invention may contain a volatile solvent in order to improve operation capability. Examples of such a volatile solvent are ketones, aromatic compounds, alcohols, cellosolves and esters. Specific examples of these are methyl ethyl ketone, methyl isobutyl ketone, 3-pentanone, 2-heptanone, benzene, toluene, xylene, ethanol, propanol, butanol, hexanol, octanol, ethylene glycol, propylene glycol, methyl cellosolve, ethyl cellosolve, butyl cellosolve, propylene glycol monoethyl ether, propylene glycol monobutyl ether, butyl carbitol, ethyl acetate, butyl acetate, acetic acid cellosolve and butyl carbitol acetate. These solvents are used alone or in combination.

The electrically conductive paste composition may further contain a filler and additive as required. Examples of the filler include silica, kaolin, titanium oxide, barite, talc, mica and clay, and examples of the additive include a fluidity regulator, antifoamer, dispersant, dye, pigment and coupling agent.

The electrically conductive paste composition of this invention can be produced by a conventional method used for the preparation of the usual coating compositions, such as a mixing method using a three-roll mill, kneader or ball mill. These methods can give a homogeneously kneaded electrically conductive paste composition.

The electrically conductive paste composition of this invention can be applied to a substrate material according to a variety of methods depending upon the purpose. For example, the paste composition can be applied by a screen printing, offset printing, gravure printing, relief printing, spray coating, roll coating, brushing, casting or spin coating method. The substrate material on which the paste is applied is not specially limited, and a wide range of substrate materials are usable: Examples of such substrate materials include not only substrates such as a paper•phenol laminate, glass•epoxy laminate, but also plastic articles and metal-processed products.

In the method of curing the electrically conductive paste composition, provided by this invention, electron beam curing can be achieved by printing or coating the electrically conductive paste composition on a substrate material and irradiating the resultant coating with an electron beam in air or inert gas atmosphere. When the electrically conductive paste composition contains a volatile solvent, the solvent may be removed at ordinary temperature or by heating the applied paste composition. The heating for the solvent removal may also work as pre-irradiation heating which will be discussed later. The electron beam irradiation can be carried out by a nonscanning method such as curtain type, laminar type, broad beam type, area beam type or pulse type or by a low-energy or medium-energy scanning method. The irradiation conditions are not specially limited. However, preferred conditions include using a current of 1 to 100 mA, an acceleration voltage of 150 to 1,000 kV and a radiation dose of 1 to 30 Mrad.

In the curing method of this invention, it is essential to heat the paste composition before, during or after the electron beam irradiation. The heating means are not specially limited, and employable are hot air heating, dielectric heating and far infrared radiation heating.

The heating time and temperature vary depending upon the composition of the paste, and it is sufficient to select such conditions that can optimize electrical conductivity and film properties. Sufficient effects can be obtained at a remarkably low temperature and for a remarkably short period of time as compared with paste compositions using a thermosetting resin alone as the binder. Examples of the temperature and time combination are 50°C/5 minutes, 270°C/20 seconds. Preferred is a combination of 100 to 250°C and 30 minutes to 15 seconds, and more preferred is 140 to 220°C and 15 minutes to 30 seconds. The heating temperature means a surface temperature of a coated material.

The electrically conductive paste composition of this invention is cured preferably by a combined use of electron beam curing and heat curing after it is printed or coated on a substrate. However, the curing by (1) electron beam only or (2) heat only may be used.

The electron beam curing can be achieved by irradiating a coated article with an electron beam in air or inert gas atmosphere. When the electrically conductive paste contains a volatile solvent, the solvent may be removed at ordinary temperature or by heating the applied paste. The heating for the solvent removal may also work as pre-irradiation heating which will be discussed later. The electron beam irradiation can be carried out by a nonscanning method such as curtain type, laminar type, broad beam type, area beam type or pulse type or by a low-energy or medium-energy scanning method. The irradiation conditions are not specially limited. However, preferred conditions include using a current of 1 to 100 mA, an acceleration voltage of 150 to 1,000 kV and a radiation dose of 1 to 30 Mrad.

The curing with heat means a reaction which takes place by heating a printed or coated paste to a temperature over room temperature, and a combination of a temperature between 50°C and 250°C and a time between several seconds and several hours is usually selected. The heating method is carried out by using a medium of hot air or warm water or irradiation with infrared radiation or far infrared radiation, and with no special limitation is imposed thereon.

The curing method using a combination of electron beam curing and heat curing is achieved by heating the printed or coated paste composition before, during or after the electron beam irradiation. By this method, sufficient effects can be obtained at a remarkably low temperature and for a remarkably short period of time as compared with paste compositions using a thermosetting resin alone as a binder.

The electrically conductive paste composition of this invention can be directly used as such after having been cured. And, it may be subjected to heat aging treatment or it may be coated with a protecting coating composition as required.

The electrically conductive paste composition of this invention may be used not only in so-called wiring circuits, but also as a shield against electromagnetic wave. It may be also used as a coating composition or adhesive in some cases. Examples of these uses include locking or caulking reinforcement, circuit repairing, volume resistor and electrode coating, condenser electrode coating, wave guide tube adhesion, liquid crystal adhesion, LED adhesion, semiconductor element adhesion, potentiometer adhesion, quartz oscillator adhesion and micromotor carbon rush adhesion.

EXAMPLES

The following Examples will illustrate this invention, which however shall not be limited thereto.

(a) Method of preparation of electrically conductive paste composition.

The components shown in Table 1 were uniformly dispersed by using a three-roll mill.

(b) Method of formation of cured film.

An electrically conductive paste composition was printed on a one surface copper-clad paper phenol laminate, which had a copper foil electrode portion formed by subjecting it to etching treatment and polishing treatment in advance, to a 1 cm by 1 cm size by using a 200 mesh stainless steel screening plate. Then, heating and electron beam irradiation were carried out under predetermined conditions to cure the electrically conductive paste composition. The heating used a far infrared radiation apparatus, and the electron beam irradiation used a UNITRON 200/200 supplied by Ushio Electric Inc. (irradiation with electron beam at an acceleration voltage of 200 kV and an absorption dose of 10 Mrad in $N_2$ gas atmosphere for about 20 seconds). A thermosetting solder resist (S-22, supplied by Taiyo Ink Manufacturing Co., Ltd.) was printed on the cured electrically conductive paste and cured at 150°C for 15 minutes.

(c) Method of cured film testing

(i) Evaluation of surface state

Surface state of an applied paste prior to the solder resist printing was observed by the eyes to evaluate the smoothness thereof.

(ii) Test on immersion in solder

A cured film was immersed in a bath of fused solder (tin 60/lead 40) at 260°C for 10 seconds.

(iii) Test on humidity resistance

A cured film was allowed to stand in a constant-temperature and constant-humidity chamber having a temperature of 60°C and a relative humidity of 90 to 95% for 500 hours.

A change ratio of bulk specific resistance value after tests (ii) and (iii) were calculated on the basis of the following equation.

Change ratio (%) = (bulk specific resistance value before test*- bulk specific resistance value* after test) / bulk specific resistance value* before test x 100

* Bulk specific resistance value Ω.cm) = {bulk specific resistance value (Ω) x width (1 cm) x length (1 cm)} / thickness of paste film ($\mu$) x $10^4$

Examples 1 - 7

Table 1 shows compositions, heating conditions and results of evaluation of pastes.

Table 1

| | Example | 1 | 2 | 3 | 4 | 5 | 6 | 7 |
|---|---|---|---|---|---|---|---|---|
| Composition (part) | MF-D2 1) | 80 | 80 | 80 | 80 | 80 | | |
| | Carbonickel: 287 2) | | | | | | | 80 |
| | Silver powder | | | | | | | 80 |
| | SP4010 3) | 10 | 5 | 10 | 10 | 10 | 10 | 10 |
| | Cymel 736 4) | 10 | 15 | | | | 10 | 10 |
| | Resitop 2772 5) | | | 10 | | | | |
| | AER 331 6) | | | | 10 | 10 | | |
| | MR-400 7) | | | | | | | |
| | p-Toluene sulfonic acid | 0.1 | 0.15 | | 0.2 | | | |
| | 2-Ethyl-4-methylimidazole | | | | | | | |
| | Butyl cellosolve | 10 | 10 | 10 | 10 | 10 | 10 | 10 |
| Heating conditions Before electron beam irradiation | | 160°C x 5 min | | | | | | |
| Evaluation results | Bulk specific resistance value ($\Omega \cdot cm$) | $2 \times 10^{-3}$ | $8 \times 10^{-4}$ | $4 \times 10^{-3}$ | $6 \times 10^{-3}$ | $5 \times 10^{-3}$ | $4 \times 10^{-3}$ | $8 \times 10^{-4}$ |
| | Surface state | Smooth | Smooth | Smooth | Smooth | Smooth | Smooth | Smooth |
| | Change ratio (%) after test on immersion in solder | -8 | -4 | -7 | -5 | -8 | -7 | -2 |
| | Change ratio (%) after test on humidity resistance | -8 | -5 | -6 | -4 | -9 | -7 | -8 |

1) Dendritic copper powder: supplied by Mitsui Mining and Smelting Co., Ltd.

2) Nickel powder: supplied by Fukuda Metal Foil Powder Kogyo K.K.

3) Epoxy acrylate: supplied by Showa Highpolymer K.K.

4) Amino resin: supplied by Mitsui-Cyanamid K.K.

5) Resol-type phenolic resin: supplied by Gun-ei Kagaku K.K.

6) Bisphenol-type epoxy resin: supplied by Asahi Chemical Industry Co., Ltd.

7) Aromatic polyisocyanate: supplied by Nippon Polyurethane K.K.

Examples 8-13

Table 2 shows compositions, heating conditions and results of evaluation of pastes in Examples 8-13.

## Table 2

| | Example | 8 | 9 | 10 | 11 | 12 | 13 |
|---|---|---|---|---|---|---|---|
| Composition (part) | MF-D$_2$ | 80 | 80 | 80 | 80 | 80 | 80 |
| | VR-60 1) | 10 | 10 | 10 | 10 | 10 | 10 |
| | Cymel 736 | 10 | 10 | 10 | 10 | 10 | 10 |
| | Linolenic acid | 0.1 | 0.5 | 1.0 | | | |
| | Linoleic acid | | | | 0.5 | 1.0 | |
| | Oleic acid | | | | | | 0.5 |
| | P-Toluene sulfonic acid | 0.1 | 0.1 | 0.1 | 0.1 | 0.1 | 0.1 |
| | Butyl cellosolve | 10 | 10 | 10 | 10 | 10 | 10 |
| Heating conditions Before electron beam irradiation | | 160°C x 5 min | | | | | |
| Evaluation results | Bulk specific resistance value (Ω·cm) | 1x10$^{-3}$ | 9x10$^{-4}$ | 1x10$^{-3}$ | 8x10$^{-4}$ | 9x10$^{-4}$ | 7x10$^{-4}$ |
| | Surface state | Smooth | Smooth | Smooth | Smooth | Smooth | Smooth |
| | Change ratio (%) after test on immersion in solder | -3 | -2 | -4 | -3 | -4 | -4 |
| | Change ratio (%) after test on humidity resistance | -4 | -2 | -4 | -3 | -4 | -5 |

1) Epoxy acrylate: supplied by Showa Highpolymer K.K.

10

Examples 14-19

Table 3 shows compositions, heating conditions and results of evaluation of pastes in Examples 14-19.

Table 3

| | Example | 14 | 15 | 16 | 17 | 18 | 19 |
|---|---|---|---|---|---|---|---|
| Composition (part) | MF-D$_2$ | 80 | 80 | 80 | 80 | 80 | 80 |
| | VR-60 | 10 | 10 | 10 | 10 | 10 | 10 |
| | Cymel 736 | 10 | 10 | 10 | 10 | 10 | 10 |
| | Catechol | 2.0 | | | | | |
| | Urushiol | | 5.0 | | | | |
| | Pyrogallol | | | 3.0 | | | |
| | Propinonylacetone | | | | 5.0 | | |
| | Acetylacetone | | | | | 5.0 | |
| | Linoleylacetone | | | | | | 6.0 |
| | p-Toluene sulfonic acid | 0.1 | 0.1 | 0.1 | 0.1 | 0.1 | 0.1 |
| | Butyl cellosolve | 10 | 10 | 10 | 10 | 10 | 10 |
| Heating conditions | | 160°C x 5 min | | | | | |
| Evaluation results | Before electron beam irradiation | | | | | | |
| | Bulk specific resistance value (Ω·cm) | 9x10$^{-4}$ | 8x10$^{-4}$ | 5x10$^{-4}$ | 1x10$^{-3}$ | 9x10$^{-4}$ | 9x10$^{-4}$ |
| | Surface state | Smooth | Smooth | Smooth | Smooth | Smooth | Smooth |
| | Change ratio (%) after test on immersion in solder | -6 | -8 | -5 | -6 | -7 | -6 |
| | Change ratio (%) after test on humidity resistance | -7 | -8 | -5 | -8 | -6 | -8 |

11

Table 4 shows compositions, heating conditions and results of evaluation of pastes in Examples 20-25.

<div align="center">Table 4</div>

| Example | 20 | 21 | 22 | 23 | 24 | 25 |
|---|---|---|---|---|---|---|
| COMPOSITION (part) | | | | | | |
| MF-D2 [1] | | | 80 | | | |
| SP4010 [2] | | | 10 | | | |
| Cymel 736 [3] | | | 10 | | | |
| p-Toluene sulfonic acid | | | 0.1 | | | |
| Butyl cellosolve | | | 10 | | | |
| HEATING CONDITIONS | | | | | | |
| Before electron beam irradiation | 140°C x 10 min | 180°C x 1 min | – | – | – | – |
| During electron beam irradiation | – | – | 140°C | 160°C | – | – |
| After electron beam irradiation | – | – | – | – | 140°C x 8 min | 160°C x 5 min |
| EVALUATION RESULTS | | | | | | |
| Bulk specific resistance value () | $5 \times 10^{-3}$ | $1 \times 10^{-3}$ | $2 \times 10^{-3}$ | $1 \times 10^{-3}$ | $7 \times 10^{-3}$ | $4 \times 10^{-3}$ |
| Surface state | Smooth | Smooth | Smooth | Smooth | Smooth | Smooth |
| Change ratio (%) after test on immersion in solder | –8 | –6 | –7 | –7 | –9 | –8 |
| Change ratio (%) after test on humidity resistance | –8 | –6 | –7 | –7 | –9 | –8 |

1)  Dendritic copper powder:  supplied by Mitsui
    Mining and Smelting Co., Ltd.

2)  Epoxy acrylate:  supplied by Showa Highpolymer
    K.K.

3)  Amino resin:  supplied by Mitsui-Cyanamid K.K.

EP 0 425 677 B1

Examples 26-28

Table 5 shows compositions, heating conditions and results of evaluation of pastes in Examples 26-28.

Table 5

| | Example | 26 | 27 | 28 |
|---|---|---|---|---|
| Composition (part) | Silver powder | | 80 | |
| | AER331 1) | | 20 | |
| | 2-Ethyl-4-ethylimidazole | | 0.4 | |
| | AsF4.diaryliodonium salt | | 0.4 | |
| | Butyl cellosolve | | 10 | |
| Heating conditions | Before electron beam irradiation | 180°C x 1 min | — | — |
| | During electron beam irradiation | — | 180°C | — |
| | After electron beam irradiation | — | — | 180°C x 1 min |
| Evaluation results | Bulk specific resistance value ($\Omega$.cm) | $4 \times 10^{-4}$ | $10^{-3}$ | $2 \times 10^{-4}$ |
| | Surface state | Smooth | Smooth | Smooth |
| | Change ratio (%) after test on immersion in solder | -4 | -5 | -4 |
| | Change ratio (%) after test on humidity resistance | -3 | -6 | -4 |

14

Examples 29-34

Table 6 shows compositions, heating conditions and results of evaluation of pastes in Examples 29-34.

Table 6

| | Example | 29 | 30 | 31 | 32 | 33 | 34 |
|---|---|---|---|---|---|---|---|
| Composition (part) | MF-D₂ | | 80 | | | 80 | |
| | SP-4010 | | 20 | | | 20 | |
| | Benzoyl peroxide | | 3 | | | 5 | |
| | Butyl cellosolve | | 10 | | | 10 | |
| Heating conditions | Before electron beam irradiation | 200°C x 20sec. | | | 200°C x 20sec. | | |
| | During electron beam irradiation | | 200°C | 200°C x 30sec. | | 200°C | 200°C x 30sec. |
| | After electron beam irradiation | | | | | | |
| Evaluation results | Bulk specific resistance value (Ω·cm) | $5 \times 10^{-4}$ | $6 \times 10^{-4}$ | $5 \times 10^{-4}$ | $3 \times 10^{-4}$ | $4 \times 10^{-4}$ | $4 \times 10^{-4}$ |
| | Surface state | Smooth | Smooth | Smooth | Smooth | Smooth | Smooth |
| | Change ratio (%) after test on immersion in solder | -6 | -7 | -6 | -3 | -4 | -3 |
| | Change ratio (%) after test on humidity resistance | -9 | -9 | -8 | -6 | -6 | -5 |

Comparative Examples 1-4

Table 7 shows compositions, heating conditions and results of evaluation of pastes in Comparative Examples 1-4.

**Table 7**

| | Comparative Example | 1 | 2 | 3 | 4 |
|---|---|---|---|---|---|
| Composition (part) | MF-D$_2$ | 80 | 80 | 10 | |
| | Silver powder | | | | 80 |
| | SP-4010 | 1 | 19 | 45 | 20 |
| | Cymel 736 | 19 | 1 | 45 | |
| | p-Toluene sulfonic acid | 0.19 | 0.01 | 0.45 | |
| | Butyl cellosolve | 10 | 10 | 5 | 10 |
| Heating conditions | Before electron beam irradiation | 160 x 5 min | 160 x 5 min | 160 x 5 min | 160 x 10min |
| | After electron beam irradiation | | | | |
| Evaluation results | Bulk specific resistance value ($\Omega \cdot cm$) | $10^{-1}$ | $2 \times 10^{-2}$ | $10^4<$ | $5 \times 10^{-4}$ |
| | Surface state | Rough | Smooth | Rough | Smooth |
| | Change ratio (%) after test on immersion in solder | -50 | -60 | - | -70 |
| | Change ratio (%) after test on humidity resistance | -100 | -70 | - | -150 |

Comparative Example 5

A film was formed from the same composition as that of Example 20 without heating before, during or after electron beam irradiation. Table 8 shows the results of evaluation of the film.

Table 8

| Bulk specific resistance value ($\Omega \cdot cm$) | $10^{-2}$ |
|---|---|
| Surface | rough |
| Change ratio after test on immersion in solder (%) | -100 |
| Change ratio after test on humidity resistance (%) | -200 |

**Claims**

1. A method of curing an electrically conductive paste composition which comprises irradiating with an electron beam and heating in combination an electrically conductive paste composition comprising
   (A) 5 to 85 parts by weight of a resin paste comprising 10 to 90% by weight of an electron beam-curable resin (a) selected from resins having unsaturated group(s) in the molecule or in the side chain thereof, and 90 to 10% by weight of at least one heat-curable resin (b) selected from an amino resin, a phenolic resin, an epoxy resin or a polyisocyanate resin, and
   (B) 95 to 15 parts by weight of an electrically conductive fine powder having an average particle diameter of 1 to 50 micrometres, wherein the heating is carried out at 100 to 250°C for 30 minutes to 15 seconds.

2. A method according to claim 1, wherein the heating is carried out at 140 to 220°C for 30 minutes to 15 seconds.

3. An electrically conductive paste composition consisting essentially of:
   (A) 5 to 85 parts by weight of a resin paste comprising 10 to 90% by weight of an electron beam-curable resin (a) selected from resins having unsaturated group(s) in the molecule or in the side chain thereof, and 90 to 10% by weight of at least one resin (b) selected from an amino resin, a phenolic resin, an epoxy resin or a polyisocyanate resin, and
   (B) 95 to 15 parts by weight of an electrically conductive fine powder having an average particle diameter of 1 to 50 micrometres.

4. A composition according to claim 3, wherein the electron beam-curable resin is epoxy (meth)acrylate.

5. A composition according to claim 3, wherein the resin (b) is an amino resin or a phenolic resin.

6. A composition according to claim 5, wherein the amino resin is a melamine resin.

7. A composition according to claim 4, wherein the resin paste comprises 15 to 50% by weight of the resin (a) and 85 to 50% by weight of the resin (b).

8. A composition according to claim 3, wherein the electrically conductive fine powder is a metallic powder.

9. A composition according to claim 8, wherein the metallic powder is a copper powder or a nickel powder.

10. A composition according to claim 9, wherein the copper powder comprises at least one copper powder selected from a copper powder having a dendritic form, a copper powder having a scale form or a copper powder having a spherical form.

17

EP 0 425 677 B1

**11.** A composition according to claim 4, which has a resin paste (A)/electrically conductive fine powder (B) mixing ratio (A/B) of 10 to 50% by weight/90 to 50% by weight.

**Patentansprüche**

**1.** Verfahren zum Härten einer elektrisch leitfähigen Pastenzusammensetzung, welches in der Kombination aus

Bestrahlen mit einem Elektronenstrahl und Erhitzen einer elektrisch leitfähigen Pastenzusammensetzung besteht, welche:

(A) 5 bis 85 Gew.-Teile einer Harzpaste, die 10 bis 90 Gew.-% eines durch Elektronenstrahlung härtbaren Harzes(a), das unter Harzen ausgewählt ist, die in dem Molekül oder in dessen Seitenkette ungesättigte Gruppen aufweisen, und 90 bis 10 Gew.-% mindestens eines wärmehärtbaren Harzes (b), das unter einem Aminoharz, einem Phenolharz, einem Epoxyharz oder einem Polyisocyanatharz ausgewählt ist, enthält, und

(B) 95 bis 15 Gew.-Teile eines elektrisch leitfähigen feinen Pulvers mit einem durchschnittlichen Teilchendurchmesser von 1 bis 50 $\mu$m umfaßt,

wobei das Erhitzen auf 100 bis 250°C während 30 Minuten bis 15 Sekunden durchgeführt wird.

**2.** Verfahren nach Anspruch 1, wobei das Erhitzen auf 140 bis 220°C während 30 Minuten bis 15 Sekunden durchgeführt wird.

**3.** Elektrisch leitfähige Pastenzusammensetzung, welche im wesentlichen aus den folgenden Bestandteilen besteht:

(A) 5 bis 85 Gew.-Teilen einer Harzpaste, die 10 bis 90 Gew.-% eines mittels Elektronenstrahlung härtbaren Harzes (a), das unter Harzen ausgewählt ist, die in dem Molekül oder dessen Seitenkette ungesättigte Gruppen aufweisen, und 90 bis 10 Gew.-% mindestens eines Harzes (b), das unter einem Aminoharz, einem Phenolharz, einem Epoxyharz oder einem Polyisocyanatharz ausgewählt ist, enthält, und

(B) 95 bis 15 Gew.-Teile eines elektrisch leitfähigen feinen Pulvers mit einem durchschnittlichen Teilchendurchmesser von 1 bis 50$\mu$m.

**4.** Zusammensetzung nach Anspruch 3, worin das mittels Elektronenstrahlung härtbare Harz Epoxy(meth)-acrylat ist.

**5.** Zusammensetzung nach Anspruch 3, worin das Harz (b) ein Aminoharz oder ein Phenolharz ist.

**6.** Zusammensetzung nach Anspruch 5, worin das Aminoharz ein Melaminharz ist.

**7.** Zusammensetzung nach Anspruch 4, worin die Harzpaste 15 bis 50 Gew.-% des Harzes (a) und 85 bis 50 Gew.-% des Harzes (b) umfaßt.

**8.** Zusammensetzung nach Anspruch 3, worin das elektrisch leitfähige feine Pulver ein Metallpulver ist.

**9.** Zusammensetzung nach Anspruch 8, worin das Metallpulver ein Kupferpulver oder ein Nickelpulver ist.

**10.** Zusammensetzung nach Anspruch 9, worin das Kupferpulver mindestens ein Kupferpulver umfaßt, das unter Kupferpulver mit einer dentritischen Form, Kupferpulver mit Schuppenform oder einem Kupferpulver mit Kugelform ausgewählt ist.

**11.** Zusammensetzung nach Anspruch 4, die ein Mischungsverhältnis (A/B) von Harzpaste (A)/elektrisch leitfähigem feinem Pulver (B) von 10 bis 50 Gew.-%/90 bis 50 Gew.-% aufweist.

**Revendications**

**1.** Procédé de durcissement d'une composition pâteuse conductrice de l'électricité, qui consiste, en combinaison, à exposer à un faisceau d'électrons et à chauffer une composition pâteuse conductrice de l'électricité comprenant

18

(A) de 5 à 85 parties en poids d'une pâte de résine comprenant de 10 à 90 % en poids d'une résine (a) susceptible de durcir sous l'effet d'un faisceau d'électrons choisie parmi les résines ayant des groupes insaturés dans la molécule ou dans la chaîne latérale et de 90 à 10 % d'au moins une résine (b) thermodurcissable choisie parmi une résine amino, une résine phénolique, une résine époxy ou une résine de polyisocyanate, et
(B) de 95 à 15 parties en poids d'une fine poudre conductrice de l'électricité ayant un diamètre moyen des particules de 1 à 50 micromètres, le chauffage étant effectué entre 100 et 250°C pendant 30 minutes à 15 secondes.

2. Procédé suivant la revendication 1, dans lequel le chauffage est effectué entre 140 et 220°C pendant 30 minutes à 15 secondes.

3. Composition pâteuse conductrice de l'électricité consistant essentiellement en :
(A) de 5 à 85 parties en poids d'une pâte de résine comprenant de 10 à 90 % en poids d'une résine (a) susceptible de durcir sous l'effet d'un faisceau d'électrons choisie parmi les résines ayant des groupes insaturés dans la molécule ou dans la chaîne latérale et de 90 à 10 % d'au moins une résine (b) thermodurcissable choisie parmi une résine amino, une résine phénolique, une résine époxy ou une résine de polyisocyanate, et
(B) de 95 à 15 parties en poids d'une fine poudre conductrice de l'électricité ayant un diamètre moyen des particules de 1 à 50 micromètres.

4. Composition suivant la revendication 3, dans laquelle la résine durcissable sous l'effet d'un faisceau d'électrons est un époxy (méth)acrylate.

5. Composition suivant la revendication 3, dans laquelle la résine (b) est une résine amino ou une résine phénolique.

6. Composition suivant la revendication 5, dans laquelle la résine amino est une résine mélamine.

7. Composition suivant la revendication 4, dans laquelle la pâte de résine comprend de 15 à 50 % en poids de la résine (a) et de 85 à 50 % de la résine (b).

8. Composition suivant la revendication 3, dans laquelle la fine poudre conductrice de l'électricité est une poudre métallique.

9. Composition suivant la revendication 8, dans laquelle la poudre métallique est une poudre de cuivre ou une poudre de nickel.

10. Composition suivant la revendication 9, dans laquelle la poudre de cuivre comprend au moins une poudre de cuivre choisie parmi une poudre de cuivre ayant une forme dendritique, une poudre de cuivre ayant une forme en paillettes ou une poudre de cuivre ayant une forme sphérique.

11. Composition suivant la revendication 4, qui a un rapport (A/B) de mélange de la pâte de résine (A) à la fine poudre (B) conductrice de l'électricité de 10 à 50 % en poids/90 à 50 % en poids.